# EUROPÄISCHE PATENTSCHRIFT

(11) **EP 3 721 315 B1**
(45) Veröffentlichungstag und Bekanntmachung des Hinweises auf die Patenterteilung: **23.10.2024**
(21) Anmeldenummer: 18808397.6
(22) Anmeldetag: 04.12.2018
(51) Int. Cl.: G06F 1/16, H01R 12/72, H05K 7/14

(54) **ELEKTRONIKGERÄT MIT EINER LEITERPLATTE**
ELECTRONIC DEVICE HAVING A PRINTED CIRCUIT BOARD
APPAREIL ÉLECTRONIQUE AVEC CARTE DE CIRCUIT IMPRIMÉ

(30) Priorität: 08.12.2017 BE 201705921; 08.12.2017 DE 102017129288
(43) Veröffentlichungstag der Anmeldung: 14.10.2020
(73) Patentinhaber: Phoenix Contact GmbH & Co. KG, 32825 Blomberg (DE)
(72) Erfinder: EUSTERHOLZ, Helmut, 33102 Paderborn (DE)
(86) Internationale Anmeldenummer: PCT/EP2018/083539
(87) Internationale Veröffentlichungsnummer: WO 2019/110612

(56) Entgegenhaltungen:
- EP-A1- 2 399 435
- DE-C1- 19 514 767
- DE-C1- 4 428 687
- DE-U1- 8 805 257
- US-A1- 2005 174 723

## Beschreibung

Die Erfindung betrifft ein Elektronikgerät nach dem Oberbegriff des Anspruchs 1 sowie ein Verfahren zum Herstellen eines Elektronikgeräts.

Ein derartiges Elektronikgerät umfasst ein Gehäuse, das zwei entlang einer Anreihrichtung zueinander beabstandete, zwischen sich einen Aufnahmeraum ausbildende Seitenwandungen aufweist. Eine Leiterplatte, die eine entlang der Einschubrichtung erstreckte Seitenkante aufweist, kann entlang einer quer zur Anreihrichtung weisenden Einschubrichtung in den Aufnahmeraum des Gehäuses eingesetzt werden und ist in einer Montagestellung in einer senkrecht zur Anreihrichtung erstreckten Stellung in dem Aufnahmeraum aufgenommen.

Ein derartiges Elektronikgerät kann beispielsweise zusammen mit anderen Elektronikgeräten entlang der Anreihrichtung kombiniert werden, sodass eine Mehrzahl von Elektronikgeräten entlang der Anreihrichtung aneinander angereiht sind. Das Elektronikgerät kann beispielsweise zusammen mit den anderen Elektronikgeräten an einer Tragschiene aufgenommen werden, sodass auf diese Weise eine elektrische Baugruppe geschaffen wird, die beispielsweise Steuer- oder Auswertefunktionen im Rahmen einer industriellen Anlage übernehmen kann.

Elektronische Bauteile sind hierbei auf der Leiterplatte angeordnet, die in das Gehäuse eingesetzt werden kann, um das Elektronikgerät auszubilden. Die Leiterplatte erstreckt sich in der Montagestellung parallel zu den Seitenwandungen, zwischen denen der Aufnahmeraum gebildet ist, und ist in dem Gehäuse in geschützter Weise eingefasst.

Wünschenswert ist eine Elektronikgerät, dass einfach, insbesondere zum Einsetzen und Fixieren der Leiterplatte in dem Gehäuse, montiert werden kann, dabei aber variabel auch in Abhängigkeit von der Ausgestaltung von elektronischen Bauteilen der Leiterplatte zum Beispiel mit Anschlüssen oder auch Anzeige- und Bedienelementen bestückbar ist.

Bei einem aus der DE 44 28 687 C1 bekannten Elektronikgerät kann eine Leiterplatte zusammen mit einem an Bedienelementen der Leiterplatte vormontierten Gehäuseteil in ein Gehäuse eingesetzt werden. In montierter Stellung verschließt das Gehäuseteil eine Öffnung des Gehäuses.

Bei einem aus der EP 2 399 435 B1 bekannten Elektronikgerät werden Gehäuse mit Anschlusskammern an einer Leiterplatte vormontiert. Die Leiterplatte kann sodann zusammen mit Seitenteilen an einem Gehäusesockel angeordnet werden, um das Elektronikgerät zu komplettieren. Ergänzend sind Elektronikgeräte der betreffenden Art bekannt aus DE 88 05257 U1 oder EP 2399435 A1, bei denen eine Anpassung des Gehäuseinnenraums durch verschieden breite Gehäuseseiten modular erfolgt, um dadurch unterschiedliche Leiterplatten einhausen zu können. DE 44 28 687 C1 betrifft ein Elektronikgerät, das in ein Gehäuse einschiebbar ist und eine Gehäusewandung an Bauteilen einer bestückten Leiterplatte gehalten sind, derart, dass beim Einschieben der Leiterplatte eine parallel zur Leiterplatte angeordnete Gehäusewand komplettiert wird. DE 195 14767 C1 lehrt einen Aufbau eines Elektronikgeräts, bei dem Komponenten in einen becherförmigen Aufnahmeraum entlang einer gemeinsamen Einschubrichtung eingeschoben werden und dieser abschließend mit einem Deckel versehen wird. US 2005/174723 A1 kennzeichnet ein Elektronikgerät, bei dem ein Gehäuserand durch einzelne Ansetzteile zum Verblenden einer Seitenwand bestückt wird, wobei die Ansetzteile nicht an einer Seitenkante der Leiterplatte angeordnet wird.

Gemäß dem Stand der Technik stellt das Ansetzteil ein Blendenteil für einen mit der Leiterplatte (elektrisch) verbundenen elektrischen Anschluss bereit. Demnach weist zumindest ein Ansetzteil zumindest eine Eingriffsaufnahme auf, mit der das zumindest eine Ansetzteil an die Seitenkante der Leiterplatte ansetzbar und in einer angesetzten Stellung mit der Leiterplatte verbunden ist.

Aufgabe der vorliegenden Erfindung ist es, ein Elektronikgerät sowie ein Verfahren zum Herstellen eines in Abhängigkeit von der Anwendung konfigurierbaren Elektronikgeräts bereitzustellen, die eine einfache und somit kostengünstige Montage des Elektronikgeräts bei variabler Bestückbarkeit insbesondere mit elektrischen und/oder mechanischen Anschlüssen ermöglichen.

Diese Aufgabe wird durch einen Gegenstand mit den Merkmalen des Anspruchs 1 gelöst.

Erfindungsgemäß weisen die Ansetzteile je zwei erste Führungseinrichtungen zur Führung an zweiten Führungseinrichtungen der Seitenwandungen des Gehäuses auf. Die Ansetzteile sind zusammen mit der Leiterplatte an dem Gehäuse montierbar derart, dass bei Einsetzen der Leiterplatte in den Aufnahmeraum die Ansetzteile über die ersten Führungseinrichtungen an den zweiten Führungseinrichtungen der Seitenwandungen des Gehäuses entlang der Einschubrichtung verschiebbar geführt sind und in der Montagestellung die Seitenwandungen formschlüssig miteinander verbinden.

Das zumindest eine Ansetzteil ist somit mit der Eingriffsaufnahme an die Seitenkante der Leiterplatte angesetzt und wird insbesondere kraftschlüssig oder formschlüssig an der Leiterplatte gehalten.

An die Leiterplatte können somit in modularer Weise Ansetzteile angesetzt werden, die in angesetzter Stellung kraftschlüssig oder formschlüssig mit der Leiterplatte verbunden sind. Die Ansetzteile weisen hierzu jeweils eine Eingriffsaufnahme auf, mit der die Ansetzteile an eine Seitenkante der Leiterplatte angesetzt werden können und die beispielsweise schlitzförmig zur Aufnahme der Seitenkante der Leiterplatte geformt sein kann. Über solche Ansetzteile können funktionale Baugruppen an der Leiterplatte bereitgestellt werden. Die Ansetzteile können hierbei auch, wie nachfolgend noch beschrieben werden soll, zur Verbindung der Leiterplatte mit dem Gehäuse dienen und in der Montagestellung das Gehäuse derart komplettieren, dass der Aufnahmeraum, in dem die Leiterplatte aufgenommen ist, nach außen abgeschlossen ist. Hierzu können die Ansetzteile eine formschlüssigen Verbindung mit den Seitenwandungen des Gehäuses eingehen.

Dadurch, dass die Verbindung der Ansetzteile mit der Leiterplatte in kraftschlüssiger oder formschlüssiger Weise durch Eingriff der Eingriffsaufnahme mit einer zugeordneten Seitenkante der Leiterplatte erfolgt, ergibt sich eine einfache Montage, zu der die Ansetzteile (lediglich) an eine zugeordnete Seitenkante der Leiterplatte angesetzt werden müssen. Unterschiedliche Ansetzteile können hierbei miteinander kombiniert werden, um die Leiterplatte nach gewünschter Funktion und Ausgestaltung mit einer geeigneten Kombination von Ansetzteilen zu bestücken.

Die Eingriffsaufnahme des Ansetzteils kann beispielsweise an einem von einem Körper vorstehenden Steg des Ansetzteils geformt und schlitzförmig ausgestaltet sein. In die Eingriffsaufnahme wird die Leiterplatte mit ihrer Seitenkante eingesteckt, um das Ansetzteil kraftschlüssig oder formschlüssig mit der Leiterplatte zu verbinden.

Zum Herstellen einer formschlüssigen Verbindung kann das Ansetzteil beispielsweise einen Rasthaken aufweisen, der bei Ansetzen des Ansetzteils an die Leiterplatte (geringfügig) deformiert wird und nach Erreichen der angesetzten Stellung in eine zugeordnete Rastöffnung der Leiterplatte schnappt. Über einen solchen Rasthaken und dessen Eingriff in die Rastöffnung der Leiterplatte wird das Ansetzteil somit an der Leiterplatte festgelegt derart, dass das Ansetzteil nicht ohne weiteres, zumindest nicht ohne Lösen der Verrastung, von der Leiterplatte entfernt werden kann.

Zum Herstellen einer kraftschlüssigen Verbindung kann die Eingriffsaufnahme beispielsweise eine Presspassung mit der zugeordneten Seitenkante der Leiterplatte bilden, indem die (schlitzförmige) Eingriffsaufnahme eine lichte Weite aufweist, die kleiner als die Stärke der Leiterplatte im Bereich der Seitenkante ist oder eine Verengung in der Eingriffsaufnahme durch eine Fixiernase gebildet ist. Bei Ansetzen des Ansetzteils an die Leiterplatte entsteht somit ein Kraftschluss.

In einer Ausgestaltung weist das Ansetzteil mehrere quer zur Einschubrichtung zueinander beabstandete Eingriffsaufnahmen zum Verbinden des Ansetzteils mit mehreren parallel zueinander erstreckten, in das Gehäuse einzusetzenden Leiterplatten auf. Über das Ansetzteil können somit mehrere Leiterplatten miteinander verbunden und in definierter Stellung zueinander gehalten werden.

In einer konkreten Ausgestaltung kann das Ansetzteil zwei quer zur Einschubrichtung zueinander versetzte (Gruppen von) Eingriffsaufnahmen aufweisen, über die das Ansetzteil mit zwei parallel zueinander ausgerichteten Leiterplatten verbunden werden kann.

Durch Verbinden eines oder mehrerer Ansetzteile mit einer oder mehreren Leiterplatten wird eine vormontierte Baueinheit geschaffen, die als solche in den Aufnahmeraum des Gehäuses eingesetzt werden kann. Sind mehrere Leiterplatten vorgesehen, können über die Ansetzteile die Leiterplatten miteinander verbunden und in definierter Stellung zueinander gehalten werden, sodass die Leiterplatten gemeinsam in den Aufnahmeraum des Gehäuses eingesetzt werden können.

In einer Ausgestaltung weist die Leiterplatte entlang der Einschubrichtung erstreckte, einander gegenüberliegende Seitenkanten auf, an denen Ansetzteile angeordnet werden können. Die Ansetzteile werden somit an gegenüberliegenden Seitenkanten der Leiterplatte aneinander angereiht und miteinander kombiniert, sodass die Ansetzteile in einem mit der Leiterplatte verbundenen Zustand sich entlang der Seitenkanten der Leiterplatte erstrecken.

Ein oder mehrere Ansetzteilen können an der Leiterplatte vormontiert werden, um die Leiterplatte zusammen mit den daran angeordneten Ansetzteilen in das Gehäuse einzusetzen. In der Vormontagestellung sind die Ansetzteile mit der Leiterplatte verbunden und bilden somit zusammen mit der Leiterplatte eine vormontierte Baueinheit, die an das Gehäuse des Elektronikgeräts angesetzt werden kann. Das Ansetzen dieser vormontierten Baueinheit erfolgt dann, gemäß einer vorteilhaften Ausgestaltung, in geführter Weise dadurch, dass erste Führungseinrichtungen der Ansetzteile mit zweiten Führungseinrichtungen der Seitenwandungen des Gehäuses in Eingriff gebracht werden, sodass die Baueinheit, also die Ansetzteile zusammen mit der Leiterplatte, in das Gehäuse eingeschoben werden kann und die Leiterplatte in eine definierte Lage innerhalb des Aufnahmeraums gelangt. In der Montagestellung fixieren die Ansetzteile die Leiterplatte in dem Aufnahmeraum, indem die Leiterplatte über die Ansetzteile mit den Seitenwandungen verbunden ist. Die Ansetzteile erstrecken sich hierbei zwischen den Seitenwandungen und verbinden die Seitenwandungen formschlüssig miteinander, sodass das Gehäuse komplettiert ist und die Ansetzteile beispielsweise das Gehäuse nach außen hin abschließen.

An die Leiterplatte können ganz beliebige Ansetzteile zur Bereitstellung ganz unterschiedlicher Funktionen angesetzt werden. Die Leiterplatte kann somit, abhängig von einer gewünschten Ausgestaltung und Funktion der durch die Leiterplatte bereitgestellten elektronischen Baugruppe, mit unterschiedlichen Ansetzteilen bestückt werden, um die auf diese Weise geschaffene vormontierte Baueinheit in das Gehäuse einzusetzen und dadurch das Elektronikgerät zu montieren.

Zur Montage können die ersten Führungseinrichtungen der Ansetzteile und die zweiten Führungseinrichtungen der Seitenwandungen des Gehäuses vorzugsweise derart miteinander in Eingriff gebracht werden, dass die Ansetzteile in einer senkrecht zur Einschubrichtung erstreckten Ebene fest mit den Seitenwandungen verbunden sind, entlang der Einschubrichtung aber zu den Seitenwandungen verschiebbar sind, bis die Montagestellung erreicht ist und die Leiterplatte zum Beispiel zusätzlich in der erreichten Endposition im Gehäuse verrastet. Die Ansetzteile sind somit in der senkrecht zu Einschubrichtung erstreckten Ebene zu den Seitenwandungen festgelegt, also so mit den Seitenwandungen verbunden, dass eine feste Verbindung zwischen den Ansetzteilen und den Seitenwandungen besteht, die Ansetzteile jedoch entlang der Einschubrichtung zu den Seitenwandungen verschiebbar sind, bis die Montagestellung erreicht ist. Durch den Eingriff der ersten Führungseinrichtungen mit den zweiten Führungseinrichtungen wird somit eine Führung für die Ansetzteile an den Seitenwandungen geschaffen, aufgrund derer die Ansetzteile und darüber die Leiterplatte in definierter Weise zu den Seitenwandungen verschiebbar sind, ohne dass sich die Ansetzteile dabei ohne weiteres aus ihrem geführten Eingriff mit den Seitenwandungen lösen können.

Die Führung der Ansetzteile an den Seitenwandungen kann beispielsweise dadurch bereitgestellt werden, dass jede erste Führungseinrichtung formschlüssig mit einer zugeordneten zweiten Führungseinrichtung in Eingriff bringbar ist, indem ein Eingriff eines Stegs in eine Nut hergestellt wird im Sinne einer Nut-und-Feder-Verbindung. Eine der Führungseinrichtungen weist somit einen Steg auf, die in eine zugeordnete Nut der anderen Führungseinrichtung eingreift und dadurch eine Führung entlang der Einschubrichtung bereitstellt, gleichzeitig aber die Ansetzteile in der Ebene senkrecht zur Einschubrichtung so miteinander verbindet, dass der Eingriff zwischen den Ansetzteilen und den Seitenwandungen nicht ohne weiteres lösbar ist.

In einer konkreten Ausgestaltung weisen die zweiten Führungseinrichtungen der Seitenwandungen jeweils einen Steg auf, während die ersten Führungseinrichtungen eines jeden Ansetzteils jeweils eine mit dem Steg in Eingriff bringbare Nut aufweisen. Ein jedes Ansetzteil weist somit zwei Nuten auf, die mit jeweils einem Steg einer Seitenwandung in Eingriff gebracht werden können, sodass darüber das Ansetzteil an beiden Seitenwandungen verschiebbar geführt ist, dabei aber eine nicht ohne weiteres lösbare Verbindung zwischen dem Ansetzteil und den Seitenwandungen geschaffen wird, sodass das Ansetzteil in einer senkrecht zur Einschubrichtung erstreckten Ebene zu den Seitenwandungen formschlüssig festgelegt ist.

In alternativer Ausgestaltung ist auch denkbar, dass die ersten Führungseinrichtungen der Ansetzteile jeweils einen Steg und die zweiten Führungseinrichtungen der Seitenwandungen jeweils eine Nut, mit der ein Steg einer zugeordneten ersten Führungseinrichtung in Eingriff bringbar ist, aufweisen.

In anderer Ausgestaltung ist auch denkbar, dass das Führungssystem als ganze oder halbe Schwalbenschwanzführung mit schräggestelltem Nut-Steg-System ausgeführt ist.

Der Formschluss zwischen den Führungseinrichtungen ist insbesondere derart, dass die Ansetzteile in einer senkrecht zur Einschubrichtung erstreckten Ebene zu den Seitenwandungen festgelegt sind und somit eine Verbindung zwischen den Ansetzteilen und den Seitenwandungen geschaffen ist. Um hierbei zu verhindern, dass ein Ansetzteil entlang einer Querrichtung, die quer zur Anreihrichtung und quer zur Einschubrichtung erstreckt ist, außer Eingriff von einem zugeordneten Steg gelangen kann, kann im Bereich der Nut ein Blockiersteg angeordnet sein, der den Steg in der Nut blockiert und ein Herausrutschen des Stegs aus der Nut entlang der Querrichtung verhindert. Der Steg kann beispielsweise in eine entlang der Querrichtung weisende Eingriffsrichtung in die Nut eingreifen. Der Blockiersteg blockiert eine Herausgleiten des Stegs entgegen der Eingriffsrichtung aus der Nut und sichert somit den Eingriff des Stegs in die Nut.

Um die Ansetzteile in einer senkrecht zur Einschubrichtung erstreckten Ebene fest (aber entlang der Einschubrichtung aber zu den Seitenwandungen bis in die Montagestellung verschiebbar) mit den Seitenwandungen zu verbinden, umgreift die Nut den Führungssteg vorzugsweise an vier Seiten. Stufen, die der Führungssteg mit der zugeordneten Seitenwandung bildet, sind hierbei in Anlage mit dem Blockiersteg und einem Begrenzungsabschnitt der Nut. Der Führungssteg wird somit formschlüssig in Eingriff mit der Nut gehalten und kann in einer Ebene senkrecht zur Einschubrichtung nicht aus der Nut herausbewegt werden.

In einer Ausgestaltung sind die Ansetzteile in der Montagestellung entlang der Anreihrichtung zwischen den Seitenwandungen erstreckt. Die Ansetzteile können sich beispielsweise flächig entlang der Anreihrichtung und der Einschubrichtung erstrecken und können beispielsweise eine Begrenzung des Aufnahmeraums nach außen hin bereitstellen, sodass die Ansetzteile das Gehäuse komplettieren und zusammen mit anderen Gehäuseabschnitten den Aufnahmeraum des Gehäuses nach außen hin abschließen.

Die Ansetzteile können beispielsweise, betrachtet in einer durch die Anreihrichtung und die Einschubrichtung aufgespannten Ebene, jeweils einen Körper aufweisen, der ein Flächenelement bereitstellt, das betrachtet entlang der Einschubrichtung eine Teilung des jeweiligen Ansetzteils definiert. Der Körper kann beispielsweise eine rechteckige Grundform (in einer durch die Anreihrichtung und die Einschubrichtung aufgespannten Ebene) aufweisen, mit einer Teilung, die einer vorbestimmten kleinsten Teilungseinheit oder einem ganzzahligen Vielfachen der vorbestimmten kleinsten Teilungseinheit entspricht. Mehrere Ansetzteile können entlang der Einschubrichtung aneinander angereiht und aneinander anschließend an der Leiterplatte angeordnet werden, sodass die Leiterplatte in modularer Weise mit unterschiedlichen Kombinationen von Ansetzteilen bestückt werden kann.

Im Rahmen eines Baukastensystems können somit mehrere unterschiedliche Ansetzteile bereitgestellt werden, die variabel und in unterschiedlicher Weise miteinander kombiniert werden können. Dadurch, dass die Ansetzteile eine Teilung aufweisen, die einer vorbestimmten kleinsten Teilungseinheit oder einem ganzzahligen Vielfachen der vorbestimmten kleinsten Teilungseinheit entspricht, können grundsätzlich beliebige Kombinationen von Ansetzteilen derart entlang der Einschubrichtung aneinander angereiht werden, dass sich eine Kombination von Ansetzteilen mit einer vorbestimmten Gesamtlänge ergibt, entsprechend zum Beispiel der Länge einer Gehäuseöffnung (gemessen entlang der Einschubrichtung), die durch die Ansetzteile zu verschließen ist. Eine Leiterplatte kann somit mit ganz unterschiedlichen Kombinationen von Ansetzteilen bestückt werden, um zusammen mit den Ansetzteilen in den Aufnahmeraum des Gehäuses eingesetzt zu werden und somit das Elektronikgerät auszubilden.

Durch die Verwendung unterschiedlicher Ansetzteile in Kombination miteinander können unterschiedliche Funktionen an der Leiterplatte bereitgestellt werden, wie dies nachstehend noch erläutert werden soll. Es ergibt sich somit ein flexibel verwendbares Baukastensystem, mittels dessen ganz unterschiedliche Elektronikgeräte in variabler Weise hergestellt und anwendungsbezogen konfiguriert werden können. Die Ansetzteile können hierbei insbesondere eine Geräteschnittstelle von der Leiterplattenbaustufe des hergestellten Elektronikgeräts nach Außen bereitstellen.

Die vorbestimmte kleinste Teilungseinheit (kurz: TE; englisch: Unit) definiert eine Grundlänge entlang der Einschubrichtung. Einige Ansetzteile können beispielsweise eine Teilung entsprechend der einfachen Teilungseinheit aufweisen. Andere Ansetzteile können eine Teilung entsprechend der doppelten Teilungseinheit aufweisen, also doppelt so lang wie die Teilungseinheit sein. Wiederum andere Ansetzteile können beispielsweise eine Teilung entsprechend dem Dreifachen der Teilungseinheit aufweisen. Unterschiedliche Ansetzteile können somit entlang der Einschubrichtung miteinander kombiniert werden, um eine Kombination von Ansetzteilen mit einer vorbestimmten Länge zu schaffen. Weist beispielsweise eine Gehäuseöffnung, in die die Kombination von Ansetzteilen einzuschieben ist, eine Länge entsprechend der fünffachen Teilungseinheit auf, so können Ansetzteile derart miteinander kombiniert werden, dass sich die Gesamtlänge entsprechend der fünffachen Teilungseinheit ergibt.

Die Ansetzteile sind hierbei derart an der Leiterplatte anzuordnen, dass sie entlang der Anreihrichtung von der Leiterplatte vorstehen. Während die Leiterplatte sich entlang einer durch die Einschubrichtung und die Querrichtung aufgespannten Ebene flächig erstreckt, sind die Ansetzteile an den entlang der Einschubrichtung erstreckten Seitenkanten der Leiterplatte angeordnet und stehen senkrecht zur Ebene der flächig erstreckten Leiterplatte, also entlang der Anreihrichtung, gegenüber der Leiterplatte.

Zur Montage der Leiterplatte in dem Gehäuse wird die Leiterplatte mit einer Kombination von Ansetzteilen bestückt und zusammen mit den Ansetzteilen in das Gehäuse eingesetzt. Hierbei kann vorzugsweise vorgesehen sein, dass die Leiterplatte in der Montagestellung (ausschließlich) über die Ansetzteile in dem Aufnahmeraum des Gehäuses fixiert ist, sodass eine Verbindung zwischen der Leiterplatte und dem Gehäuse (nur) mittelbar über die Ansetzteile geschaffen wird. Die Leiterplatte wird somit über die Ansetzteile in dem Aufnahmeraum des Gehäuses festgelegt.

Die Ansetzteile können ganz unterschiedliche Funktionen übernehmen und hierzu ganz unterschiedlich ausgestaltet sein.

Hierzu kann das Ansetzteil beispielsweise eine Öffnung aufweisen über die ein Steckverbinderteil mit dem elektrischen Anschluss verbunden werden kann.

In anderer Ausgestaltung kann das Ansetzteil beispielsweise eine Klemmeneinrichtung verwirklichen, die ein oder mehrere Stecköffnungen aufweist, in die elektrische Leiter (zum Beispiel mit abisolierten Leitungsenden) oder optische Leiter (Lichtwellenleiter) zum Zwecke der elektrischen oder optischen Kontaktierung eingesteckt werden können. Eine solche Klemmeneinrichtung kann beispielsweise als Federkraftklemme oder dergleichen verwirklicht sein. Unterschiedliche Klemmeneinrichtungen können hierbei Stecköffnungen zum Einstecken unterschiedlicher elektrischer Leiter mit unterschiedlichem Leitungsquerschnitt aufweisen. Klemmeneinrichtungen verschiedener Poldichte (also einer der Anschlusszahl entsprechenden Polzahl pro Teilungseinheit) zum Anschließen unterschiedlicher Leiter können somit miteinander kombiniert und an der Leiterplatte angeordnet werden.

Denkbar und möglich ist aber auch, dass ein Ansetzteil ein flächiges Wandungselement (ohne weitere elektrische Funktion) zum Verschließen des Gehäuses nach außen verwirklicht. Ein solches flächiges Wandungselement kann beispielsweise einen Abschluss das Gehäuse bereitstellen. Ein solches flächiges Wandungselement kann dabei auch als sogenannter Spacer dienen, um eine räumliche Separierung zwischen elektrischen Bauelementen, zum Beispiel zwischen elektrischen Anschlüssen, bereitzustellen und eine elektrische Wechselwirkung zwischen den elektrischen Bauelementen zu verhindern (im Sinne einer Vergrößerung einer Kriechstrecke).

In wiederum anderer Ausgestaltung kann das Ansetzteil auch ein Gitterelement bereitstellen, über das zum Beispiel eine Kühlung für eine in dem Aufnahmeraum eingefasste elektronische Baugruppe bereitgestellt werden kann.

Die Ansetzteile können auch Bedienelemente wie zum Beispiel Schalter (zum Beispiel DIP-Schalter), Regler (zum Beispiel für ein Potentiometer), Anzeigen zum Beispiel in Form von Leuchtdioden oder Displays, eine elektrische Sicherung oder auch mechanische oder elektrische Funktionselemente zum Beispiel in Form eines Schraubanschluss zur Befestigung des Gehäuses an einer anderen Baugruppe, zum Beispiel innerhalb eines Schaltschranks, oder auch in Form einer Schirmungsauflage zum Herstellen einer elektromagnetischen Schirmung oder einer Zugentlastung für ein daran festzulegendes Kabel bereitstellen.

Unterschiedliche Ansetzteile können hierbei eine unterschiedliche Farbgebung aufweisen, welche eine elektrotechnische Funktion signalisieren (wie z.B. L/N/PE, EXi, +/-, Signalart, Safety oder dergleichen, die üblicherweise durch eine spezifische Farbkennzeichnung angezeigt werden). Dies hat den technischen Vorteil, dass eine nachträgliche lokale Bedruckung des Gehäuses, wie bei herkömmlichen Elektronikgeräten, entfallen kann. Soll ein Gehäuse eines Elektronikgeräts abschnittsweise eine bestimmte Farbgebung oder Markierung aufweisen, so kann ein entsprechendes Ansetzteil verwendet und an das Gehäuse angesetzt werden, um somit eine gewünschte Farbgebung oder Markierung bereitzustellen.

Das Elektronikgerät kann vorzugsweise mit anderen Elektronikgeräten kombiniert werden, indem die Elektronikgeräte entlang der Anreihrichtung aneinander angereiht und zum Beispiel an einer Tragschiene befestigt werden. Das Elektronikgerät kann hierzu eine Befestigungseinrichtung, zum Beispiel in Form einer Rasteinrichtung, aufweisen, über die das Elektronikgerät an der Tragschiene festgelegt werden kann.

Die Aufgabe wird auch gelöst durch ein Verfahren zum Herstellen eines Elektronikgeräts, bei dem eine Leiterplatte entlang einer Einschubrichtung in einen Aufnahmeraum eines Gehäuses eingesetzt wird, der zwischen zwei Seitenwandungen gebildet ist, die entlang einer quer zur Einschubrichtung weisenden Anreihrichtung zueinander beabstandet sind, und in einer Montagestellung in einer senkrecht zur Anreihrichtung erstreckten Stellung in dem Aufnahmeraum aufgenommen ist. Dabei ist vorgesehen, dass zumindest ein Ansetzteil mit zumindest einer Eingriffsaufnahme an eine Seitenkante der Leiterplatte angesetzt wird und in einer angesetzten Stellung mit der Leiterplatte verbunden ist.

Die vorangehend für das Elektronikgerät beschriebenen Vorteile und vorteilhaften Ausgestaltungen finden analog auch auf das Verfahren Anwendung, sodass diesbezüglich auf das vorangehend Ausgeführte verwiesen werden soll.

Der der Erfindung zugrunde liegende Gedanke soll nachfolgend anhand der in den Figuren dargestellten Ausführungsbeispiele näher erläutert werden. Es zeigen:
- Fig. 1: eine perspektivische Ansicht eines Ausführungsbeispiels eines Elektronikgeräts;
- Fig. 2: eine andere perspektivische Ansicht des Elektronikgeräts;
- Fig. 3: eine Ansicht des Elektronikgeräts bei der Montage;
- Fig. 4: eine ausschnittsweise vergrößerte Ansicht im Ausschnitt A gemäß Fig. 3;
- Fig. 5: eine Ansicht des Elektronikgeräts bei der Montage;
- Fig. 6: eine andere Ansicht des Elektronikgeräts bei der Montage;
- Fig. 7: eine Ansicht des Elektronikgeräts bei der weiteren Montage;
- Fig. 8: eine Ansicht des Elektronikgeräts vor der Komplettierung durch einen Gehäusedeckel;
- Fig. 9: eine Ansicht von unterschiedlichen Ausführungsbeispielen von Ansetzteilen eines Baukastensystems;
- Fig. 10: eine Ansicht einer Leiterplatte zusammen mit daran angeordneten An setztei l en;
- Fig. 11: eine Ansicht einer Leiterplatte bei einem Ansetzen eines Ansetzteils an die Leiterplatte;
- Fig. 12: eine Ansicht der Leiterplatte mit angesetztem Ansetzteil;
- Fig. 13: eine Schnittansicht eines anderen Ausführungsbeispiels einer Leiterplatte beim Ansetzen des Ansetzteils;
- Fig. 14: die Schnittansicht gemäß Fig. 13, mit angesetztem Ansetzteil;
- Fig. 15: eine perspektivische, teilweise geschnittene Ansicht der Leiterplatte, mit angesetztem Ansetzteil entsprechend der Ansicht gemäß Fig. 14;
- Fig. 16: eine Ansicht einer Leiterplatte mit daran anzusetzenden Ansetzteilen;
- Fig. 17: eine Ansicht eines Elektronikgeräts mit montierter Leiterplatte und Ansetzteilen;
- Fig. 18: eine Ansicht eines Ausführungsbeispiels mit zwei Leiterplatten und daran anzusetzenden Ansetzteilen;
- Fig. 19: eine Ansicht des Ausführungsbeispiels gemäß Fig. 18, mit angesetzten Ansetzteilen; und
- Fig. 20: eine ausschnittsweise Schnittansicht der Anordnung gemäß Fig. 19 im Bereich von Seitenkanten der Leiterplatten.

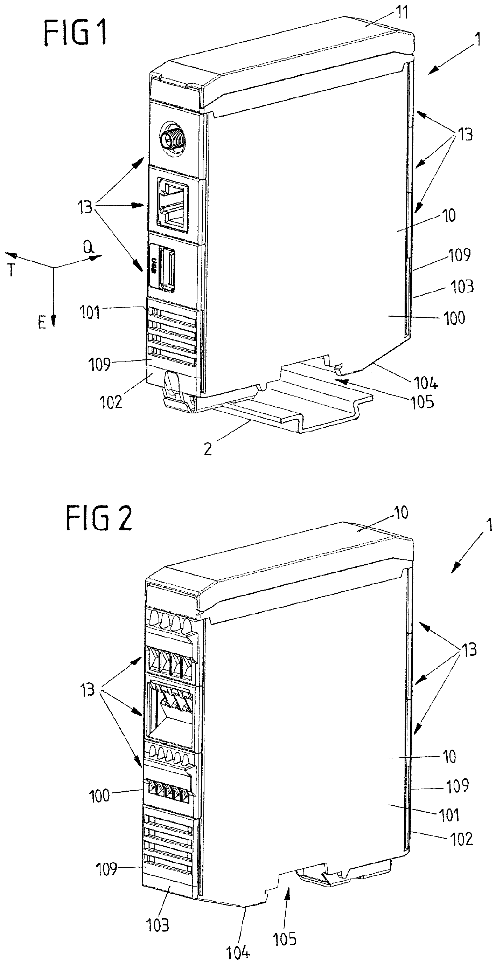

- Fig. 1 und 2: zeigen ein Ausführungsbeispiel eines Elektronikgeräts 1, das ein Gehäuse 10 und eine in dem Gehäuse 10 eingefasste elektronische Baugruppe in Form einer

Leiterplatte und daran angeordneten Elektronikkomponenten aufweist. Das Elektronikgerät 1 kann über eine Befestigungseinrichtung 105 an einer Unterseite 104 des Gehäuses 10 an eine Tragschiene 2 angesetzt und dabei entlang einer Anreihrichtung T in aneinander angereihter Weise mit anderen Elektronikgeräten 1 kombiniert werden.

Das Gehäuse 10 weist zwei senkrecht zur Anreihrichtung T erstreckte, entlang der Anreihrichtung T zueinander beabstandete Seitenwandungen 100, 101 sowie Stirnseiten 102, 103 auf, die das im wesentlichen quaderförmige Gehäuse 10 definieren. Die Seitenwandungen 100, 101 sind flächig erstreckt derart, dass andere Elektronikgeräte 1 beidseits an das Elektronikgerät 1 angesetzt und mit dem Elektronikgerät 1 an einer Tragschiene 2 kombiniert werden können.

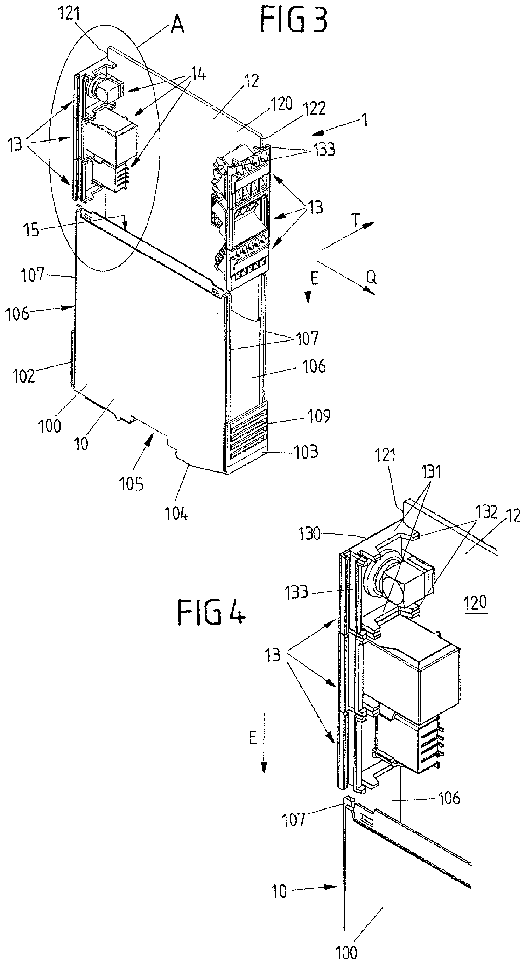

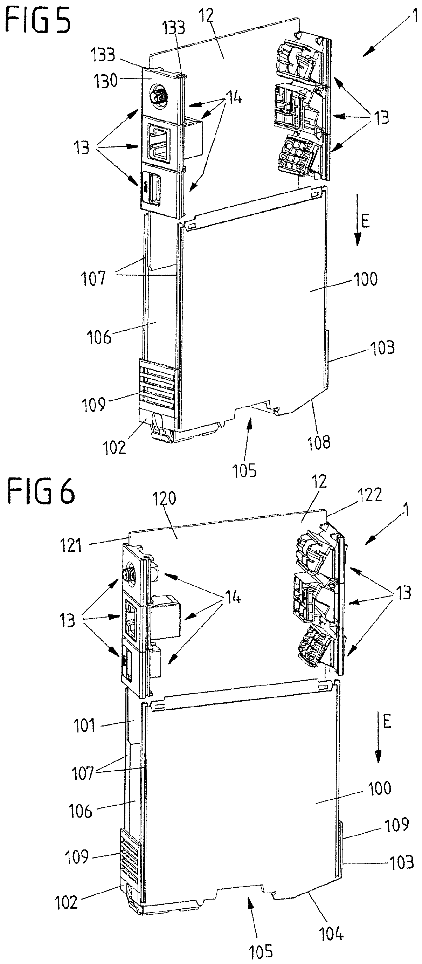

Wie dies aus Fig. 3 bis 8, in denen unterschiedliche Phasen bei der Montage des Elektronikgeräts 1 dargestellt sind, ersichtlich ist, bilden die Seitenwandungen 100, 101 zwischen sich einen Aufnahmeraum 15, in den eine Leiterplatte 12 in eine Einschubrichtung E eingesetzt werden kann derart, dass in einer Montagestellung die Leiterplatte 12 in dem Aufnahmeraum 15 aufgenommen und dabei parallel zu den Seitenwandungen 100, 101 erstreckt ist. An der Leiterplatte 12 können unterschiedliche Elektronikkomponenten, zum Beispiel Elektronikbausteine in Form von elektronischen Schaltkreisen, angeordnet sein, die eine Elektronikbaugruppe des Elektronikgeräts 1 ausbilden.

An die Leiterplatte 12 sind Ansetzteile 13 anzuordnen, die unterschiedliche Funktionen aufweisen können und zusammen mit der Leiterplatte 12 an dem Gehäuse 10 montiert werden. Die Ansetzteile 13 werden an entlang der Einschubrichtung E erstreckten Seitenkanten 121, 122 der Leiterplatte 12 angeordnet und stehen in verbundener Stellung entlang der Anreihrichtung T von einer Oberfläche 120 der Leiterplatte 12 vor.

Das Elektronikgerät 1 kann mittels eines Baukastensystems hergestellt werden, im Rahmen dessen eine Kombination von aus einer Vielzahl von unterschiedlichen Ansetzteilen 13 ausgewählten Ansetzteilen 13 an der Leiterplatte 12 angeordnet und die Leiterplatte 12 mit daran angeordneten Ansetzteilen 13 in das Gehäuse 10 eingesetzt wird, um insbesondere eine gewünschte elektrische Funktionalität für das Elektronikgerät 1 zur Verfügung zu stellen.

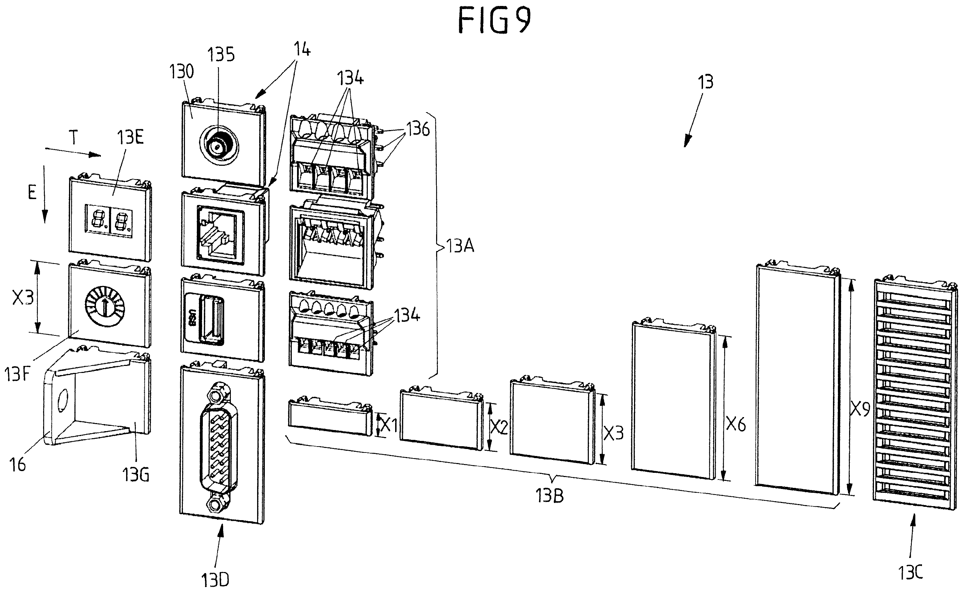

Wie aus Fig. 9 ersichtlich, können ganz unterschiedliche Ansetzteile 13 vorliegen und ein Baukastensystem ausbilden, aus dem ausgewählt werden kann, um die Leiterplatte 12 in variabler Weise zu bestücken und um an dem Elektronikgerät 1 ganz unterschiedliche Funktionalitäten bereitzustellen. Die Ansetzteile 13 weisen hierbei jeweils, betrachtet entlang der Einschubrichtung E, eine Teilung X1, X2, X3, X6, X6 auf, die einer vorbestimmten kleinsten Teilungseinheit X1 oder einem ganzzahligen Vielfachen dieser vorbestimmten kleinsten Teilungseinheit X1 entspricht. Dies ermöglicht, unterschiedliche Ansetzteile 13 in (nahezu) beliebiger Weise miteinander zu kombinieren, um eine gewünschte elektrische und/oder mechanische Funktion an der Leiterplatte 12 und dem Elektronikgerät 1 zur Verfügung zu stellen.

So weisen beispielsweise Ansetzteile 13 in Form von Wandungselementen 13B bei dem Beispiel gemäß Fig. 9 Teilungen X1, X2, X3, X6, X9 auf, die sich voneinander unterscheiden. Ein erstes Wandungselement 13B weist beispielsweise eine Teilung X1 auf, die der vorbestimmten kleinsten Teilungseinheit X1 entspricht. Ein zweites Wandungselement 13B weist demgegenüber eine Teilung X2 auf, die dem Doppelten der kleinsten Teilungseinheit X1 entspricht. Ein anderes Wandungselement 13B weist eine Teilung X3 auf, die dem Dreifachen der kleinsten Teilungseinheit X1 entspricht. Andere Wandungselemente13B weisen eine Teilung X6, X9 auf, die dem Sechsfachen bzw. dem Neunfachen der kleinsten Teilungseinheit X1 entspricht.

Ebenso weisen bei dem Beispiel gemäß Fig. 9 auch die anderen Ansetzteile 13 eine Teilung auf, die der kleinsten Teilungseinheit X1 oder einem ganzzahligen Vielfachen der kleinsten Teilungseinheit X1 entspricht. Die Ansetzteile 13 können in dieser Weise variabel miteinander kombiniert werden, um beispielsweise eine Kombination von Ansetzteilen 13 mit einer vorbestimmten Gesamtlänge zu schaffen, die genau in eine dafür vorgesehene Gehäuseöffnung 106 des Gehäuses 10 passt, wie dies zum Beispiel in Fig. 1 und 2 dargestellt ist.

Wie aus Fig. 3-8 ersichtlich, weist das Gehäuse 10 an jeder Stirnseite 102, 103 je eine Gehäuseöffnung 106 auf, die bei diesem Ausführungsbeispiel eine Länge (gemessen entlang der Einschubrichtung E) des Neunfachen der kleinsten Teilungseinheit X1 aufweist. Entsprechend können in jeder Gehäuseöffnung 106 zum Beispiel gerade drei Ansetzteile 13 mit einer Teilung X3 entsprechend der dreifachen Teilungseinheit X1 angeordnet werden, wie dies zum Beispiel aus Fig. 1 und 2 ersichtlich ist.

Die Ansetzteile 13 bilden beispielsweise Blendenteile für Anschlusseinrichtungen 14 der Leiterplatte 12 (links in Fig. 3) oder Klemmeneinrichtungen zum Anschließen elektrischer Leiter (rechts in Fig. 3) aus und werden vor dem Einsetzen der Leiterplatte 12 in den Aufnahmeraum 15 des Gehäuses 10 mit der Leiterplatte 12 verbunden, sodass eine vormontierte Baueinheit der Leiterplatte 12 mit den daran angeordneten Ansetzteilen 13 geschaffen wird, wie dies zum Beispiel aus Fig. 3 und Fig. 5 und 6 ersichtlich ist. Die so geschaffene vormontierte Baueinheit kann sodann in die Einschubrichtung E an dem Gehäuse 10 montiert werden, indem die Ansetzteile 13 an die Seitenwandungen 100, 101 des Gehäuses 10 angesetzt und in die Einschubrichtung E auf die Seitenwandungen 100, 101 aufgeschoben werden.

Die Ansetzteile 13 weisen jeweils zwei erste Führungseinrichtungen 133 in Form einer Nut auf, die mit Führungsstegen 107 an den seitlichen Kanten der Seitenwandungen 100, 101 in Eingriff gebracht werden können, um die Ansetzteile 13 auf die Seitenwandungen 100, 101 aufzuschieben und so die Leiterplatte 12 in den Aufnahmeraum 15 des Gehäuses 10 einzuführen.

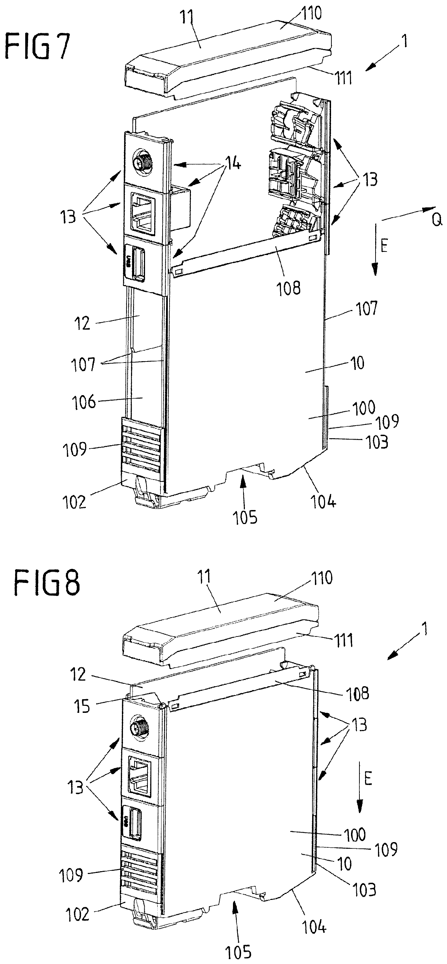

Der Aufnahmeraum 15 ist zwischen den Seitenwandungen 100, 101 gebildet, die entlang der Anreihrichtung T voneinander beabstandet sind und im Bereich der Stirnseiten 102, 103 oberhalb je eines unteren, feststehenden Wandungsabschnitts 109 Gehäuseöffnungen 106 freigeben. Durch Aufschieben der Ansetzteile 13 mit den Nuten der Führungseinrichtungen 133 auf die Führungsstege 107 der Seitenwandungen 100, 101 werden die Ansetzteile 13 - wie dies aus Fig. 7 ersichtlich ist - derart zwischen die Seitenwandungen 100, 101 geschoben, dass die Öffnungen 106 im Bereich der Stirnseiten 102, 103 verschlossen werden und das Gehäuse 10 an seinen Stirnseiten 102, 103 somit durch die unteren, feststehenden Wandungsabschnitte 109 zusammen mit den Ansetzteilen 13 verschlossen ist, wie dies aus Fig. 8 ersichtlich ist.

Nach Einsetzen der aus den Ansetzteilen 13 und der Leiterplatte 12 bestehenden vormontierten Baueinheit wird das Gehäuse 10 durch einen Gehäusedeckel 11 verschlossen, sodass die Leiterplatte 12 nicht aus dem Aufnahmeraum 15 herausfallen kann und somit in dem Aufnahmeraum 15 gesichert ist. Der Gehäusedeckel 11 weist, wie aus Fig. 8 ersichtlich, einen Körper 110 auf, an dem seitliche Stege 111 gebildet sind, die mit Verbindungstegen 108 an den oberen Kanten der Seitenwandungen 100, 101 verrasten, wenn der Gehäusedeckel 11 an das Gehäuse 10 angesetzt wird.

In der Montagestellung ist die Leiterplatte 12 in dem Aufnahmeraum 15 des Gehäuses 10 eingefasst. Die Seitenwandungen 100, 101 sind seitlich über die Ansetzteile 13 miteinander verbunden, sodass der Aufnahmeraum 15 des Gehäuses 10 seitlich über die Ansetzteile 13 abgeschlossen ist.

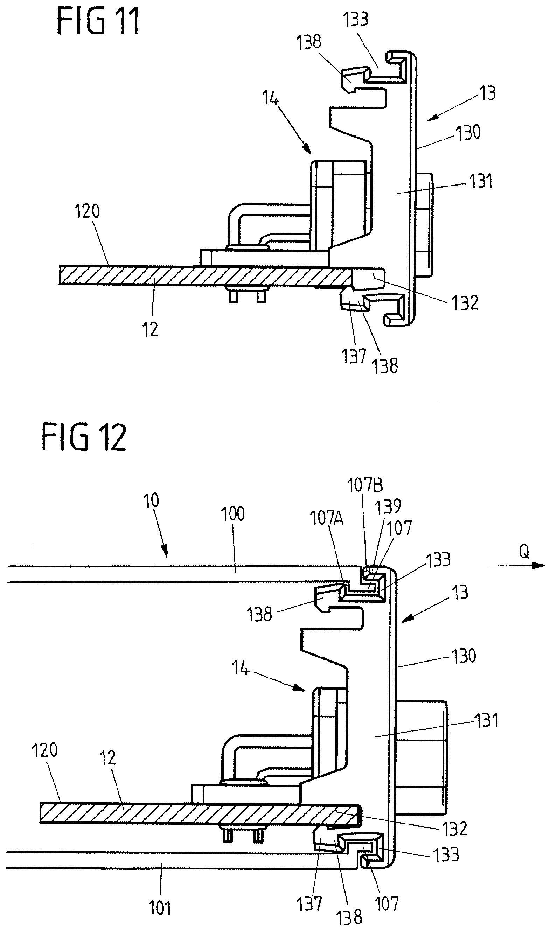

Das Ansetzen der Ansetzteile 13 an die Seitenwandungen 100, 101 des Gehäuses 10 erfolgt in geführter Weise, indem die ersten Führungseinrichtungen 133 der Ansetzteile 13 mit den zweiten Führungseinrichtungen 107 der Seitenwandungen 100, 101 formschlüssig in Eingriff gebracht werden und die Ansetzteile 13 in die Einschubrichtung E in geführter Weise zu den Seitenwandungen 100, 101 verschoben werden. Wie dies zum Beispiel aus der vergrößerten Ansicht gemäß Fig. 4 in Zusammenschau mit Fig. 12 ersichtlich ist, sind die Führungseinrichtungen 133 der Ansetzteile 13 durch Nuten gebildet, die längs entlang der Einschubrichtung E erstreckt sind und einen Eingriff mit einem jeweils zugeordneten Führungssteg 107 an der Seitenkante einer zugeordneten Seitenwandung 100, 101 bereitstellen derart, dass eine in einer Ebene senkrecht zur Einschubrichtung E feste Verbindung zwischen den Ansetzteilen 13 und den Seitenwandungen 101, 101 geschaffen wird, die Ansetzteile 13 entlang der Einschubrichtung E aber zu den Seitenwandungen 100, 101 verschiebbar sind. Eine jede Führungseinrichtung 133 weist hierzu einen rückseitig der Nut geformten, entlang der Einschubrichtung E erstreckten Blockiersteg 138 auf, der den Eingriff eines zugeordneten Führungsstegs 107 in der Nut der Führungseinrichtung 133 sichert derart, dass der Führungssteg 107 nicht entlang der Querrichtung Q außer Eingriff von der Nut der Führungseinrichtung 133 gelangen kann.

Ein jeder Führungssteg 107 bildet zu der zugeordneten Seitenwandung 100, 101 Stufen 107A, 107B aus, die mit dem Blockiersteg 138 sowie mit einem äußeren Begrenzungsabschnitt 139 der Nut der Führungseinrichtung 133 in Anlage sind, sodass darüber der Führungssteg 107 gleitend in der Führungseinrichtung 133 des zugeordneten Ansetzteils 13 gehalten ist und nicht, betrachtet in einer Ebene quer zur Einschubrichtung E, aus der Not heraus gelangen kann, wie dies in Fig. 12 dargestellt ist. Es besteht somit ein formschlüssiger Umgriff für den Führungssteg 107 in der Nut der Führungseinrichtung 133, aufgrund dessen der Führungssteg 107 in der Führungseinrichtung 133 formschlüssig (aber entlang der Einschubrichtung E verschiebbar) gehalten ist.

Diese Ausgestaltung der Führungseinrichtungen 133 und der Führungsstege 107 bewirkt, dass die Ansetzteile 13 in definierter Weise auf die Seitenwandungen 100, 101 aufgeschoben werden können. Dies bewirkt zudem, dass in der Montagestellung eine feste Verbindung zwischen den Ansetzteilen 13 und den Seitenwandungen 100, 101 geschaffen wird, die belastbar ist und ein (ungewolltes) Lösen der Ansetzteile 13 von den Seitenwandungen 100, 101 zuverlässig verhindert.

Wie zum Beispiel aus Fig. 3 und 4 ersichtlich, sind beidseits der Leiterplatte 12 an den Seitenkanten 121, 122 jeweils eine Mehrzahl von entlang der Einschubrichtung E aneinander anschließenden, benachbarten Ansetzteilen 13 angeordnet. Die Ansetzteile 13 weisen jeweils einen Körper 130 auf, der eine quadratische Grundform (betrachtet in einer durch die Einschubrichtung E und die Anreihrichtung T aufgespannten Ebene) aufweist, sodass unterschiedliche Ansetzteile 13 in modularer Weise miteinander kombiniert und an der Leiterplatte 12 angeordnet werden können.

Die Ansetzteile 13 sind Bestandteil eines Baukastensystems und können in einer gewünschten Kombination ausgewählt werden, um ein Elektronikgerät 1 mit bestimmungsgemäßer Funktionalität herzustellen. Die Ansetzteile 13 können hierbei ganz unterschiedliche Funktionen übernehmen können ganz unterschiedlich gestaltet sein, wie dies in einer Übersichtsdarstellung in Fig. 9 dargestellt ist.

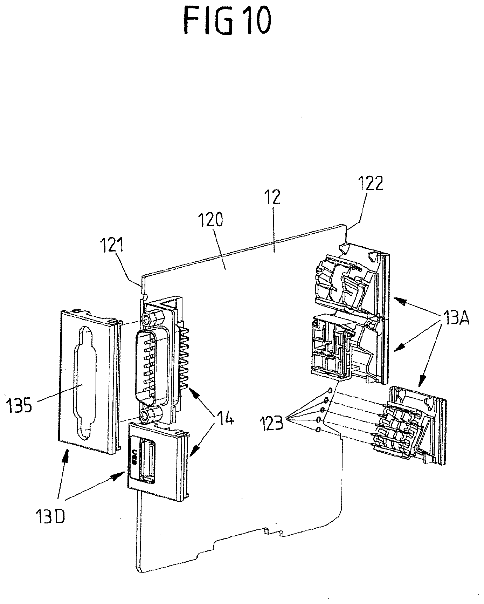

So können Ansetzteile 13 als Klemmeneinrichtungen 13A ausgestaltet sein, die zum Beispiel Stecköffnung 134 aufweisen, in die elektrische Leiter (mit abisolierten Leiterenden) eingesteckt werden können, um die elektrischen Leiter an eine zugeordnete Leiterplatte 12 anzuschließen. Über elektrische Kontaktstifte 136 können die Klemmeneinrichtungen 13A an Kontaktöffnungen 123 der Leiterplatte 12 (siehe Fig. 10) angeordnet werden, um die Klemmeneinrichtungen 13A elektrisch und mechanisch an der Leiterplatte 12 festzulegen. Die Klemmeneinrichtungen 13A können beispielsweise als Federkraftanschlüsse oder dergleichen verwirklicht sein und ein (einfaches) Anschließen elektrischer Leiter ermöglichen.

Unterschiedliche Klemmeneinrichtungen 13A können unterschiedlich dimensionierte Stecköffnungen 134 zur Aufnahme von Leitern unterschiedlichen Leitungsquerschnitts aufweisen, wie dies aus Fig. 9 ersichtlich ist. So weisen die in Fig. 9 oben dargestellte Klemmeneinrichtung 13A und die in Fig. 9 unten dargestellte Klemmeneinrichtung 13A unterschiedlich dimensionierte Stecköffnungen 134 zum Einstecken von Leitern mit unterschiedlichem Leiterquerschnitt auf.

In alternativer Ausgestaltung können Ansetzteile 13 auch als Wandungselemente 13B ausgestaltet sein, die einen flächigen Abschluss für das Gehäuse 10 bereitstellen und unterschiedliche Größen aufweisen können.

In wiederum alternativer Ausgestaltung können Ansetzteile 13 Gitterelemente 13C bereitstellen, über die beispielsweise eine Kühlung für eine in dem Gehäuse 10 eingefasste Elektronikbaugruppe bereitgestellt werden kann.

In wiederum anderer Ausgestaltung können die Ansetzteile 13 Blendenteile 130 verwirklichen, die an elektrische Anschlusseinrichtungen 14, zum Beispiel Steckverbinder zum Bereitstellen eines koaxialen Anschlusses, eines Netzwerkanschlusses, eines USB-Anschlusses oder einer parallelen oder seriellen Schnittstelle, angesetzt werden können. Die Blendenteile 130 weisen Öffnungen 135 auf, über die ein Anschließen von Steckverbindern an die Anschlusseinrichtungen 14 möglich ist.

Denkbar möglich sind auch andere Ausgestaltungen von Ansetzteilen 13. Beispielsweise können die Ansetzteile 13 Bedienelemente 13F (zum Beispiel Schalter), Anzeigen 13E (LEDs, Displays) oder auch mechanische Funktionskomponenten 13G zum Beispiel mit einem außen abstehenden Schraubflansch 16 zur Fixierung des Gehäuses 10 an einer externen Baueinheit oder dergleichen bereitstellen.

Die Ansetzteile 13 sind an der Leiterplatte 12 anzuordnen, um auf diese Weise eine vormontierte Baueinheit zu schaffen, die an dem Gehäuse 10 zum Komplettieren des Elektronikgeräts 1 montiert werden kann. Bei dem Ausführungsbeispiel gemäß Fig. 10 sind Ansetzteile 13 in Form von Klemmeneinrichtungen 13A dadurch mit der Leiterplatte 12 verbunden, dass Kontaktstifte 136 in zugeordnete Kontaktöffnungen 123 (siehe Fig. 9 und 10 an den) eingesetzt und mit der Leiterplatte 12 z.B. verlötet werden, sodass eine elektrische und mechanische Verbindung mit der Leiterplatte 12 geschaffen wird. Andere Ansetzteile 13 hingegen (bei dem Ausführungsbeispiel gemäß Fig. 10 Blendenteile 13D) sind kraftschlüssig oder formschlüssig mit der Leiterplatte 12 verbunden.

Solche Ansetzteile 13 weisen, wie dies aus Fig. 3 und 4 in Zusammenschau mit Fig. 11 bis 15 ersichtlich ist, Eingriffsaufnahmen 132 an Stegen 131 aufweisen, mit denen ein jedes Ansetzteil 13 auf eine zugeordnete Seitenkante 121, 122 der Leiterplatte 12 aufgesteckt werden kann, wie dies zum Beispiel aus dem Übergang von Fig. 11 hin zu Fig. 12 ersichtlich ist. An dem Ansetzteil 13 ist bei eine Fixiernase 137 geformt, die beim Ansetzen eine kraftschlüssige oder formschlüssige Verbindung bewirkt.

Bei dem Ausführungsbeispiel gemäß Fig. 11 und 12 beispielsweise wird die zugeordnete Seitenkante 121, 122 der Leiterplatte 12 klemmend in den Eingriffsaufnahmen 132 aufgenommen dadurch, dass die Fixiernasen 137 der Eingriffsaufnahmen 132 (unter geringfügiger Deformation) pressend gegen die Leiterplatte 12 drücken und somit einen Kraftschluss herstellen.

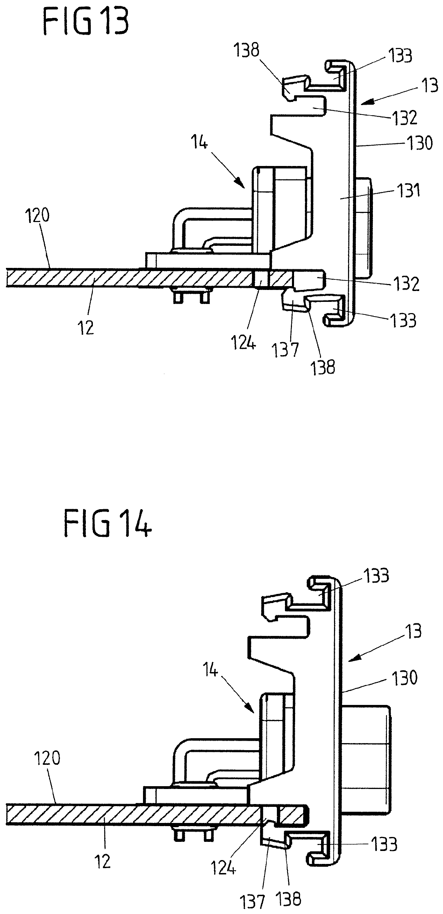

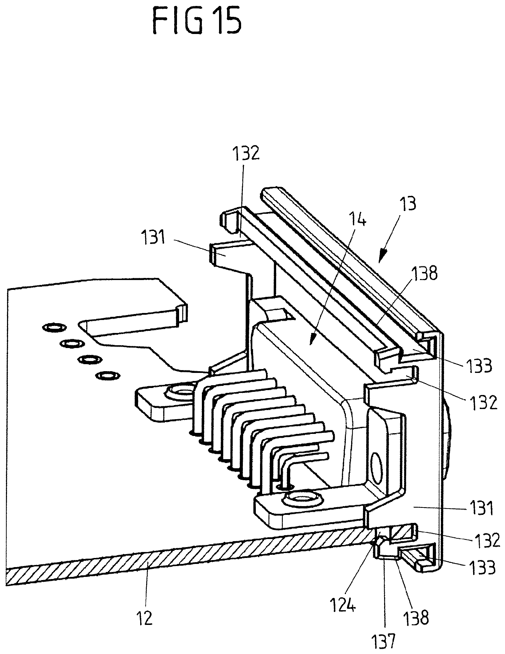

Bei dem Ausführungsbeispiel gemäß Fig. 13 bis 15 hingegen greifen die Fixiernasen 137 nach Ansetzen des jeweiligen Ansetzteils 13 an die Leiterplatte 12 in zugeordnete Rastöffnungen 124 der Leiterplatte 12 ein, sodass ein Formschluss hergestellt wird, aufgrund dessen das Ansetzteil 13 an der Leiterplatte 12 gehalten ist. Eine jede Fixiernase 137 schnappt bei Ansetzen des Ansetzteils 13 an die zugeordnete Seitenkante 121, 122 der Leiterplatte 12 in Eingriff mit einer zugeordneten Rastöffnung 124 der Leiterplatte 12, sodass in angesetzter Stellung eine rastende, formschlüssige Verbindung zwischen dem Ansetzteil 13 und der Leiterplatte 12 geschaffen ist, wie dies aus dem Übergang von Fig. 13 hin zu Fig. 14 und zudem in Fig. 15 ersichtlich ist.

Das jeweilige Ansetzteil 13 kann somit in einfacher Weise an der Leiterplatte 12 angeordnet werden und ist in angesetzter Stellung kraftschlüssig oder formschlüssig mit der Leiterplatte 12 verbunden.

In anderer Ausgestaltung kann auf eine Fixiernase 137 gegebenenfalls auch verzichtet werden. In diesem Fall bilden die Eingriffsaufnahmen 132 beispielsweise eine Presspassung mit der zugeordneten Seitenkante 121, 122 der Leiterplatte 12, indem die Eingriffsaufnahmen 132 (betrachtet entlang der Anreihrichtung T) eine lichte Weite aufweisen, die kleiner ist als die Wandungsstärke der Leiterplatte 12 im Bereich der zugeordneten Seitenkante 121, 122, sodass das Ansetzteil 13 pressend an die zugeordnete Seitenkante 121, 122 anzusetzen ist und in angesetzter Stellung kraftschlüssig an der Seitenkante 121, 122 gehalten wird.

Ist die aus der Leiterplatte 12 und den Ansetzteilen 13 gebildete Baugruppe dann an das Gehäuse 10 angesetzt, wird die Stellung der Ansetzteile 13 an der Leiterplatte 12 durch Formschluss mit dem Gehäuse 10 zusätzlich fixiert, und die Leiterplatte 12 wird über die Ansetzteile 13 in Position in dem Gehäuse 10 gehalten.

Dadurch, dass Ansetzteile 13 in einfacher Weise an eine zugeordnete Seitenkante 121, 122 der Leiterplatte 12 angesetzt werden können und in angesetzter Stellung kraftschlüssig oder formschlüssig mit der Leiterplatte 12 verbunden sind, ergibt sich eine einfache Montage zur Anordnung der Ansetzteile 13 an der Leiterplatte 12. Insbesondere kann die Montage werkzeuglos dadurch erfolgen, dass die Ansetzteile 13 mit ihren Eingriffsaufnahmen 132 jeweils in Eingriff mit einer zugeordneten Seitenkante 121, 122 der Leiterplatte 12 gebracht und auf die Seitenkante 121, 122 aufgesteckt werden, sodass eine kraftschlüssige oder formschlüssige Verbindung hergestellt wird.

Die Eingriffsaufnahmen 132 sind schlitzförmig geformt. Die Eingriffsaufnahmen 132 eines jeden Ansetzteils 13 sind an entlang der Einschubrichtung E zueinander beabstandeten, quer zum Körper 130 des Ansetzteils 13 vorstehenden Stegen 131 geformt. Wie dies zum Beispiel aus Fig. 4 ersichtlich ist, ist das Ansetzteil 13 somit über zwei entlang der Einschubrichtung E zueinander versetzte Eingriffsaufnahmen 132 an der zugeordneten Seitenkante 121, 122 der Leiterplatte 12 kraftschlüssig oder formschlüssig festgelegt.

Ein Rasthaken 137 ist hierbei im Bereich einer jeden Eingriffsaufnahme 132 geformt. Bei Ansetzen des Ansetzteils 13 an die zugeordnete Seitenkante 121, 122 der Leiterplatte 12 werden die Rasthaken 137 (geringfügig) ausgelenkt und schnappen, nach Erreichen der angesetzten Stellung (Fig. 14 und 15), in Eingriff mit Rastöffnungen 124 der Leiterplatte 120, sodass das Ansetzteil 13 kraftschlüssig oder formschlüssig an der Leiterplatte 12 festgelegt ist.

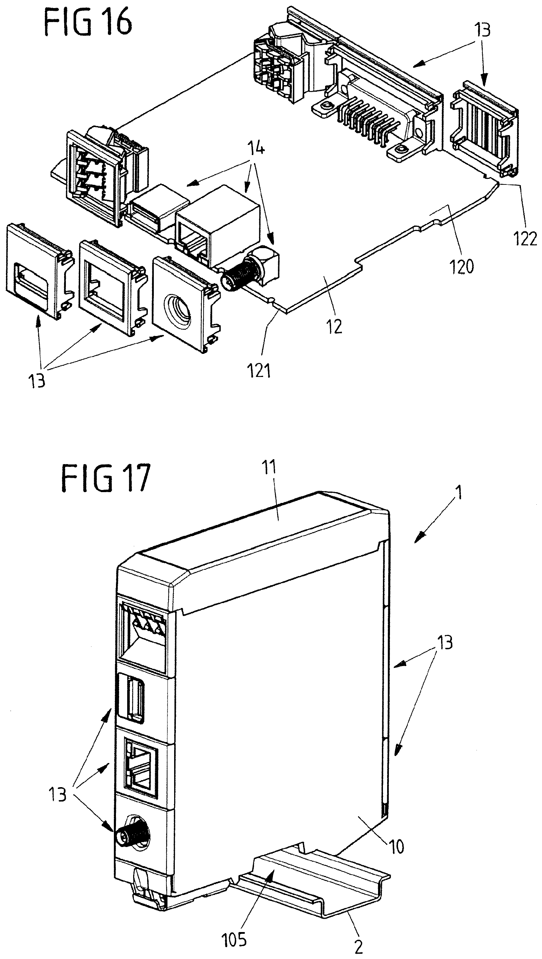

Fig. 16 und 17 zeigen ein anderes Ausführungsbeispiel einer Leiterplatte 12 mit daran anzusetzenden Ansetzteilen 13. Die Ansetzteile 13 können als Blendenteile für Anschlusseinrichtungen 14 in Form unterschiedlicher Steckverbinder dienen, können aber auch beispielsweise ein Gehäuseelement oder ein Gitterelement bereitstellen.

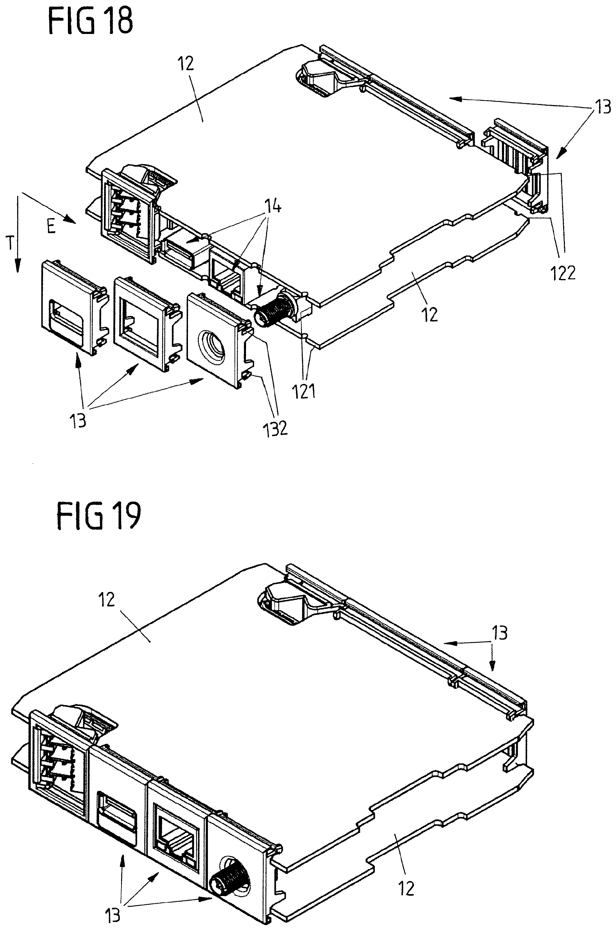

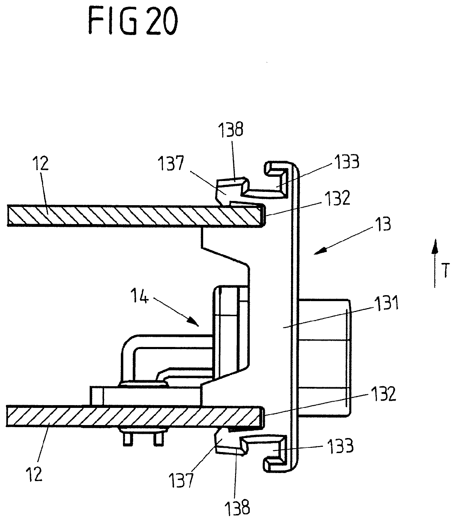

Ein jedes Ansetzteil 13 weist - bei den dargestellten Ausführungsbeispielen - Eingriffsaufnahmen 132 auf, die quer zur Einschubrichtung E, nämlich entlang der Anreihrichtung T, zueinander versetzt an den Stegen 131 geformt sind. Dies ermöglicht, wie dies in Fig. 18 bis 20 dargestellt ist, zwei parallel zueinander erstreckte Leiterplatten 12 über die Ansetzteile 13 miteinander zu verbinden, sodass eine die zwei Leiterplatten 12 umfassende, vormontierte Baueinheit geschaffen wird, die als solche in dem Aufnahmeraum 15 des Gehäuses 10 montiert werden kann.

Die Ansetzteile 13 werden zum Schaffen der vormontierten Baueinheit mit ihren quer zur Einschubrichtung E, nämlich entlang der Anreihrichtung T, zueinander versetzten Eingriffsaufnahmen 132 kraftschlüssig oder formschlüssig an zugeordnete Seitenkanten 121, 122 der parallel zueinander ausgerichteten Leiterplatten 12 angesetzt und gehen auf diese Weise eine kraftschlüssige oder formschlüssige Verbindung mit den Leiterplatten 12 ein. In angesetzter Stellung (Fig. 19) sind die Leiterplatten 12 über die Ansetzteile 13 fest miteinander verbunden und können somit gemeinsam in dem Aufnahmeraum 15 des Gehäuses 10 montiert werden. In der Montagestellung sind die Leiterplatten 12 dann über die Ansetzteile 13 in dem Aufnahmeraum 15 des Gehäuses 10 fixiert und werden sowohl zueinander als auch zu dem Gehäuse 10 belastbar in Position gehalten.

Der der Erfindung zugrunde liegende Gedanke ist nicht auf die vorangehenden Ausführungsbeispiele beschränkt, sondern lässt sich auch in gänzlich andersgearteter Weise verwirklichen.

Ein Elektronikgerät der hier beschriebenen Art kann ganz unterschiedliche Funktionen zum Beispiel zum Steuern von elektrischen Maschinen, zum Auswerten von Sensorsignalen, zum Bereitstellen einer Stromversorgung oder dergleichen übernehmen. Ein Elektronikgerät der hier beschriebenen Art kann hierbei mit anderen elektrischen oder elektronischen Baugruppen an einer Tragschiene kombiniert werden, sodass eine komplexe elektrische Anlage zum Beispiel in einem Schaltschrank geschaffen werden kann.

### Bezugszeichenliste

- 1: Elektronikgerät
- 10: Gehäuse
- 100, 101: Seitenwandung
- 102, 103: Stirnseite
- 104: Unterseite
- 105: Befestigungseinrichtung
- 106: Öffnung
- 107: Führungskante
- 107A, 107B: Stufen
- 108: Verbindungssteg
- 109: Wandungsabschnitt
- 11: Gehäusedeckel
- 110: Körper
- 111: Steg
- 12: Leiterplatte
- 120: Oberfläche
- 121, 122: Seitenkante
- 123: Kontaktöffnungen
- 124: Rastöffnung
- 13, 13A-13G: Ansetzteil
- 130: Körper
- 131: Steg
- 132: Eingriffsaufnahme
- 133: Führungseinrichtung
- 134: Stecköffnung
- 135: Öffnung
- 136: Kontaktstifte
- 137: Fixiernase
- 138: Blockiersteg
- 139: Begrenzungssteg
- 14: Anschlusseinrichtung
- 15: Aufnahmeraum
- 16: Schraubflansch
- 2: Tragschiene
- E: Einschubrichtung
- Q: Querrichtung
- T: Anreihrichtung
- X1, X2, X3, X6, X9: Teilung

## Patentansprüche

1. Elektronikgerät (1), mit einem Gehäuse (10), das zwei entlang einer Anreihrichtung (T) zueinander beabstandete, zwischen sich einen Aufnahmeraum (15) ausbildende Seitenwandungen (100, 101) aufweist, und einer Leiterplatte (12), die entlang einer quer zur Anreihrichtung (T) weisenden Einschubrichtung (E) in den Aufnahmeraum (15) des Gehäuses (10) einsetzbar und in einer Montagestellung in einer senkrecht zur Anreihrichtung (T) erstreckten Stellung in dem Aufnahmeraum (15) aufgenommen ist und eine entlang der Einschubrichtung (E) erstreckte Seitenkante (121, 122) aufweist, wobei zumindest ein Ansetzteil (13, 13A-13G), das zumindest eine Eingriffsaufnahme (132) aufweist, mit der das zumindest eine Ansetzteil (13, 13A-13G) an die Seitenkante (121, 122) der Leiterplatte ansetzbar und in einer angesetzten Stellung mit der Leiterplatte (12) verbunden ist, und das Ansetzteil ein Blendenteil für einen mit der Leiterplatte verbundenen elektrischen Anschluss bereitstellt, **dadurch gekennzeichnet,**
**dass** das zumindest eine Ansetzteil zwei erste Führungseinrichtungen (133) zur Führung an zweiten Führungseinrichtungen (107) der Seitenwandungen (100, 101) aufweist, wobei das zumindest eine Ansetzteil (13, 13A-13G) zusammen mit der Leiterplatte (12) an dem Gehäuse (10) montierbar ist derart, dass bei Einsetzen der Leiterplatte (12) in den Aufnahmeraum (15) das zumindest eine Ansetzteil (13, 13A-13G) über die ersten Führungseinrichtungen (133) an den zweiten Führungseinrichtungen (107) der Seitenwandungen (100, 101) des Gehäuses (10) entlang der Einschubrichtung (E) verschiebbar geführt ist und in der Montagestellung die Seitenwandungen (100, 101) formschlüssig miteinander verbindet.

2. Elektronikgerät (1) nach Anspruch 1, **dadurch gekennzeichnet, dass** die zumindest eine Eingriffsaufnahme (132) schlitzförmig an dem zumindest einen Ansetzteil (13, 13A-13G) geformt ist.

3. Elektronikgerät (1) nach Anspruch 1 oder 2, **dadurch gekennzeichnet, dass** das zumindest eine Ansetzteil (13, 13A-13G) einen Rasthaken (137) zum Eingreifen in eine Rastöffnung (124) der Leiterplatte (12) aufweist.

4. Elektronikgerät (1) nach einem der Ansprüche 1 bis 3, **dadurch gekennzeichnet, dass** das zumindest eine Ansetzteil (13, 13A-13G) mehrere quer zur Einschubrichtung (E) zueinander beabstandete Eingriffsaufnahmen (132) zum Verbinden des zumindest einen Ansetzteils (13, 13A-13G) mit mehreren parallel zueinander erstreckten, in das Gehäuse (10) einzusetzenden Leiterplatten (12) aufweist.

5. Elektronikgerät (1) nach einem der vorangehenden Ansprüche, **dadurch gekennzeichnet, dass** zur Montage des Gehäuses (10) die ersten Führungseinrichtungen (133) und die zweiten Führungseinrichtungen (107) derart miteinander in Eingriff bringbar sind, dass das zumindest eine Ansetzteil (13, 13A-13G) in einer senkrecht zur Einschubrichtung (E) erstreckten Ebene fest mit den Seitenwandungen (100, 101) verbunden ist, entlang der Einschubrichtung (E) aber zu den Seitenwandungen (100, 101) verschiebbar ist.

6. Elektronikgerät (1) nach einem der vorangehenden Ansprüche, **dadurch gekennzeichnet, dass** jede erste Führungseinrichtung (133) mit einer zugeordneten zweiten Führungseinrichtung (107) formschlüssig durch Eingriff eines Stegs (107) in eine Nut in Eingriff bringbar ist.

7. Elektronikgerät (1) nach einem der vorangehenden Ansprüche, **dadurch gekennzeichnet, dass** die zweiten Führungseinrichtungen (107) jeweils einen Steg (107) und die ersten Führungseinrichtungen (133) jeweils eine mit dem Steg einer zugeordneten zweiten Führungseinrichtung (133) in Eingriff bringbare Nut aufweisen.

8. Elektronikgerät (1) nach Anspruch 6 oder 7, **dadurch gekennzeichnet, dass** die ersten Führungseinrichtungen (133) je einen Blockiersteg (138) aufweisen, der die Nut entlang einer senkrecht zur Einschubrichtung (E) und senkrecht zur Anreihrichtung (T) erstreckten Querrichtung (Q) begrenzt derart, dass der zugeordnete Steg entlang der Querrichtung (Q) in Eingriff mit der Nut gehalten wird.

9. Elektronikgerät (1) nach einem der vorangehenden Ansprüche, **dadurch gekennzeichnet, dass** das zumindest eine Ansetzteil (13, 13A-13G) in der Montagestellung entlang der Anreihrichtung (T) zwischen den Seitenwandungen (100, 101) erstreckt ist.

10. Elektronikgerät (1) nach einem der vorangehenden Ansprüche, **dadurch gekennzeichnet, dass** das zumindest eine Ansetzteil (13, 13A-13G) in der Montagestellung eine Begrenzung für den Aufnahmeraum (15) nach außen hin bildet.

11. Elektronikgerät (1) nach einem der vorangehenden Ansprüche, **dadurch gekennzeichnet, dass** das zumindest eine Ansetzteil (13, 13A-13G) einen Körper (130) aufweist, der, betrachtet entlang der Einschubrichtung (E), eine Teilung (X1, X2, X3, X6, X9) definiert, die einer vorbestimmten kleinsten Teilungseinheit (X1) oder einem ganzzahligen Vielfachen der vorbestimmten kleinsten Teilungseinheit (X1) entspricht, derart, dass eine Kombination von Ansetzteilen (13, 13A-13G) entlang der Einschubrichtung (E) aneinander angereiht mit der Leiterplatte (12) verbindbar ist.

12. Elektronikgerät (1) nach einem der vorangehenden Ansprüche, **dadurch gekennzeichnet, dass** die Leiterplatte (12) in der Montagestellung über das zumindest eine Ansetzteil (13, 13A-13G) in dem Aufnahmeraum (15) des Gehäuses (10) fixiert ist.

13. Elektronikgerät (1) nach einem der vorangehenden Ansprüche, **dadurch gekennzeichnet, dass** das zumindest eine Ansetzteil (13, 13A-13G) eine Klemmeneinrichtung mit zumindest einer Stecköffnung (134) zum Anschließen eines elektrischen Leiters, ein geschlossenes, flächiges Wandungselement zum Verschließen des Gehäuses (10) oder ein Gitterelement ausbildet.

14. Elektronikgerät (1) nach einem der vorangehenden Ansprüche, **gekennzeichnet durch** eine Befestigungseinrichtung (105) zum Verbinden des Elektronikgeräts (1) mit einer Tragschiene (2).

15. Verfahren zum Herstellen eines Elektronikgeräts (1), bei dem eine Leiterplatte (12) entlang einer Einschubrichtung (E) in einen Aufnahmeraum (15) eines Gehäuses(10) eingesetzt wird, der zwischen zwei Seitenwandungen (100, 101) gebildet ist, die entlang einer quer zur Einschubrichtung (E) weisenden Anreihrichtung (T) zueinander beabstandet sind, und in einer Montagestellung in einer senkrecht zur Anreihrichtung (T) erstreckten Stellung in dem Aufnahmeraum (15) aufgenommen ist, wobei zumindest ein Ansetzteil (13, 13A-13G) mit zumindest einer Eingriffsaufnahme (132) an eine Seitenkante (121, 122) der Leiterplatte angesetzt wird und in einer angesetzten Stellung mit der Leiterplatte (12) verbunden ist und das Ansetzteil ein Blendenteil für einen mit der Leiterplatte verbundenen elektrischen Anschluss bereitstellt,
**dadurch gekennzeichnet,**
**dass** das zumindest eine Ansetzteil zwei erste Führungseinrichtungen (133) zur Führung an zweiten Führungseinrichtungen (107) der Seitenwandungen (100, 101) aufweist, wobei das zumindest eine Ansetzteil (13, 13A-13G) zusammen mit der Leiterplatte (12) an dem Gehäuse (10) montierbar ist derart, dass bei Einsetzen der Leiterplatte (12) in den Aufnahmeraum (15) das zumindest eine Ansetzteil (13, 13A-13G) über die ersten Führungseinrichtungen (133) an den zweiten Führungseinrichtungen (107) der Seitenwandungen (100, 101) des Gehäuses (10) entlang der Einschubrichtung (E) verschiebbar geführt ist und in der Montagestellung die Seitenwandungen (100, 101) formschlüssig miteinander verbindet.

## Claims

1. Electronic appliance (1), having a housing (10), which has two side walls (100, 101), which are spaced apart from one another along a lining-up direction (T) and form a receiving space (15) between them, and a printed circuit board (12), which can be inserted into the receiving space (15) of the housing (10) along an insertion direction (E) directed transversely to the lining-up direction (T) and, in an assembled position, is received in the receiving space (15) in a position extending perpendicular to the lining-up direction (T) and has a side edge (121, 122) extending along the insertion direction (E), wherein at least one attachment part (13, 13A-13G), which has at least one engagement receptacle (132), which can be used to attach the at least one attachment part (13, 13A-13G) to the side edge (121, 122) of the printed circuit board, and, in an attached position, is connected to the printed circuit board (12), and the attachment part provides a panel part for an electrical connection connected to the printed circuit board,
**characterized**
**in that** the at least one attachment part has two first guide devices (133) for guiding on second guide devices (107) of the side walls (100, 101), wherein the at least one attachment part (13, 13A-13G) can be assembled, together with the printed circuit board (12), on the housing (10) in such a manner that, when the printed circuit board (12) is inserted into the receiving space (15), the at least one attachment part (13, 13A-13G) is guided on the second guide devices (107) of the side walls (100, 101) of the housing (10) so as to be displaceable along the insertion direction (E) by way of the first guide devices (133) and, in the assembled position, connects the side walls (100, 101) to one another in a form-fitting manner.

2. Electronic appliance (1) according to Claim 1, **characterized in that** the at least one engagement receptacle (132) is formed in a slot-like manner on the at least one attachment part (13, 13A-13G).

3. Electronic appliance (1) according to Claim 1 or 2, **characterized in that** the at least one attachment part (13, 13A-13G) has a latching hook (137) for engaging in a latching opening (124) in the printed circuit board (12) .

4. Electronic appliance (1) according to one of Claims 1 to 3, **characterized in that** the at least one attachment part (13, 13A-13G) has a plurality of engagement receptacles (132), which are spaced apart from one another transversely to the insertion direction (E), for connecting the at least one attachment part (13, 13A-13G) to a plurality of printed circuit boards (12), which extend parallel to one another and are to be inserted into the housing (10).

5. Electronic appliance (1) according to one of the preceding claims, **characterized in that**, in order to assemble the housing (10), the first guide devices (133) and the second guide devices (107) can be brought into engagement with one another in such a manner that the at least one attachment part (13, 13A-13G) is connected to the side walls (100, 101) so as to be fixed in a plane extending perpendicular to the insertion direction (E), but can be displaced relative to the side walls (100, 101) along the insertion direction (E).

6. Electronic appliance (1) according to one of the preceding claims, **characterized in that** each first guide device (133) can be brought into engagement with an associated second guide device (107) in a form-fitting manner through engagement of a web (107) in a groove.

7. Electronic appliance (1) according to one of the preceding claims, **characterized in that** the second guide devices (107) each have a web (107) and the first guide devices (133) each have a groove that can be brought into engagement with the web of an associated second guide device (133).

8. Electronic appliance (1) according to Claim 6 or 7, **characterized in that** the first guide devices (133) each have a blocking web (138), which delimits the groove along a transverse direction (Q) extending perpendicular to the insertion direction (E) and perpendicular to the lining-up direction (T) in such a manner that the associated web is held in engagement with the groove along the transverse direction (Q).

9. Electronic appliance (1) according to one of the preceding claims, **characterized in that**, in the assembled position, the at least one attachment part (13, 13A-13G) extends between the side walls (100, 101) along the lining-up direction (T).

10. Electronic appliance (1) according to one of the preceding claims, **characterized in that**, in the assembled position, the at least one attachment part (13, 13A-13G) forms an outwards delimitation for the receiving space (15) .

11. Electronic appliance (1) according to one of the preceding claims, **characterized in that** the at least one attachment part (13, 13A-13G) has a body (130), which, when viewed along the insertion direction (E), defines a subdivision (X1, X2, X3, X6, X9), which corresponds to a predetermined smallest subdivision unit (X1) or to an integer multiple of the predetermined smallest subdivision unit (X1), in such a manner that a combination of attachment parts (13, 13A-13G) can be connected to the printed circuit board (12) so as to be lined up adjacent to one another along the insertion direction (E).

12. Electronic appliance (1) according to one of the preceding claims, **characterized in that**, in the assembled position, the printed circuit board (12) is fixed in the receiving space (15) of the housing (10) by way of the at least one attachment part (13, 13A-13G).

13. Electronic appliance (1) according to one of the preceding claims, **characterized in that** the at least one attachment part (13, 13A-13G) forms a clamping device having at least one plug-in opening (134) for connecting an electrical conductor, a closed, planar wall element for closing the housing (10) or a grate element.

14. Electronic appliance (1) according to one of the preceding claims, **characterized by** a fastening device (105) for connecting the electronic appliance (1) to a supporting rail (2).

15. Method for producing an electronic appliance (1), in which a printed circuit board (12) is inserted into a receiving space (15) of a housing (10) along an insertion direction (E), said receiving space being formed between two side walls (100, 101), which are spaced apart from one another along a lining-up direction (T) directed transversely to the insertion direction (E) and, in an assembled position, is received in the receiving space (15) in a position extending perpendicular to the lining-up direction (T), wherein at least one attachment part (13, 13A-13G) is attached to a side edge (121, 122) of the printed circuit board using at least one engagement receptacle (132), and, in an attached position, is connected to the printed circuit board (12), and the attachment part provides a panel part for an electrical connection connected to the printed circuit board,
**characterized**
**in that** the at least one attachment part has two first guide devices (133) for guiding on second guide devices (107) of the side walls (100, 101), wherein the at least one attachment part (13, 13A-13G) can be assembled, together with the printed circuit board (12), on the housing (10) in such a manner that, when the printed circuit board (12) is inserted into the receiving space (15), the at least one attachment part (13, 13A-13G) is guided on the second guide devices (107) of the side walls (100, 101) of the housing (10) so as to be displaceable along the insertion direction (E) by way of the first guide devices (133) and, in the assembled position, connects the side walls (100, 101) to one another in a form-fitting manner.

## Revendications

1. Appareil électronique (1), avec un boîtier (10), qui présente deux parois latérales (100, 101) espacées l'une de l'autre le long d'une direction de montage (T) et formant entre elles un espace de réception (15), et une carte à circuit imprimé (12), qui est apte à être insérée dans l'espace de réception (15) du boîtier (10) le long d'une direction d'insertion (E) orientée transversalement à la direction de montage (T) et qui, dans une position de montage, est reçue dans l'espace de réception (15) dans une position s'étendant perpendiculairement à la direction de montage (T) et qui présente un bord latéral (121, 122), au moins une pièce de raccordement (13, 13A-13G) ayant au moins un logement d'engagement (132) avec lequel ladite au moins une pièce de raccordement (13, 13A-13G) est apte à être fixée au bord latéral (121, 122) de la carte à circuit imprimé et est connectée à la carte à circuit imprimé (12) dans une position fixée, et la pièce de raccordement fournissant un élément de façade pour une connexion électrique connectée à la carte à circuit imprimé,
**caractérisé**
**en ce que** ladite au moins une pièce de raccordement présente deux premiers dispositifs de guidage (133) pour le guidage sur des deuxièmes dispositifs de guidage (107) des parois latérales (100, 101), ladite au moins une pièce de raccordement (13, 13A-13G) étant apte à être montée sur le boîtier (10) conjointement avec la carte à circuit imprimé (12) de telle sorte que, lors de l'insertion de la carte à circuit imprimé (12) dans l'espace de réception (15), ladite au moins une pièce de raccordement (13, 13A-13G) est guidée de manière à pouvoir coulisser le long de la direction d'insertion (E) par l'intermédiaire des premiers dispositifs de guidage (133) sur les deuxièmes dispositifs de guidage (107) des parois latérales (100, 101) du boîtier (10) et à relier entre elles les parois latérales (100, 101) par complémentarité de forme dans la position de montage.

2. Appareil électronique (1) selon la revendication 1, **caractérisé en ce que** ledit au moins un logement d'engagement (132) est formé selon une forme de fente sur ladite au moins une pièce de raccordement (13, 13A-13G).

3. Appareil électronique (1) selon la revendication 1 ou la revendication 2, **caractérisé en ce que** ladite au moins une pièce de raccordement (13, 13A-13G) présente un crochet d'encliquetage (137) destiné à s'engager dans une ouverture d'encliquetage (124) de la carte à circuit imprimé (12).

4. Appareil électronique (1) selon l'une des revendications 1 à 3, **caractérisé en ce que** ladite au moins une pièce de raccordement (13, 13A-13G) présente plusieurs logements d'engagement (132) espacés les uns des autres transversalement à la direction d'insertion (E) pour relier ladite au moins une pièce de raccordement (13, 13A-13G) à plusieurs cartes à circuit imprimé (12) s'étendant parallèlement les unes aux autres et à insérer dans le boîtier (10).

5. Appareil électronique (1) selon l'une des revendications précédentes, **caractérisé en ce que**, pour le montage du boîtier (10), les premiers dispositifs de guidage (133) et les deuxièmes dispositifs de guidage (107) sont aptes à être mis en prise les uns avec les autres de telle sorte que ladite au moins une pièce de raccordement (13, 13A-13G) est reliée de manière fixe aux parois latérales (100, 101) dans un plan s'étendant perpendiculairement à la direction d'insertion (E), mais est apte à être déplacée le long de la direction d'insertion (E) par rapport aux parois latérales (100, 101) .

6. Appareil électronique (1) selon l'une des revendications précédentes, **caractérisé en ce que** chaque premier dispositif de guidage (133) est apte à être mis en prise par complémentarité de forme avec un deuxième dispositif de guidage (107) associé, par engagement d'une barrette (107) dans une rainure.

7. Appareil électronique (1) selon l'une des revendications précédentes, **caractérisé en ce que** les deuxièmes dispositifs de guidage (107) présentent chacun une nervure (107) et les premiers dispositifs de guidage (133) présentent chacun une rainure aptes à être mise en prise avec la nervure d'un deuxième dispositif de guidage (133) associé.

8. Appareil électronique (1) selon la revendication 6 ou la revendication 7, **caractérisé en ce que** les premiers dispositifs de guidage (133) présentent chacun une barrette de blocage (138) qui délimite la rainure le long d'une direction transversale (Q) s'étendant perpendiculairement à la direction d'insertion (E) et perpendiculairement à la direction de montage (T), de telle sorte que la barrette associée est maintenue en prise avec la rainure le long de la direction transversale (Q).

9. Appareil électronique (1) selon l'une des revendications précédentes, **caractérisé en ce que** ladite au moins une pièce de raccordement (13, 13A-13G) s'étend, dans la position de montage, le long de la direction de montage (T), entre les parois latérales (100, 101).

10. Appareil électronique (1) selon l'une des revendications précédentes, **caractérisé en ce que** ladite au moins une pièce de raccordement (13, 13A-13G) forme, dans la position de montage, une limite vers l'extérieur pour l'espace de réception (15).

11. Appareil électronique (1) selon l'une des revendications précédentes, **caractérisé en ce que** ladite au moins une partie de montage (13, 13A-13G) présente un corps (130) qui, vu le long de la direction d'insertion (E), définit un pas (X1, X2, X3, X6, X9), qui correspond à une plus petite unité de division (X1) prédéterminée ou à un multiple entier de la plus petite unité de division (X1) prédéterminée, de telle sorte qu'une combinaison de pièces de connexion (13, 13A-13G) alignées les unes à côté des autres le long de la direction d'insertion (E) est apte à être reliée à la carte à circuit imprimé (12).

12. Appareil électronique (1) selon l'une des revendications précédentes, **caractérisé en ce que** la carte à circuit imprimé (12) est fixée dans l'espace de réception (15) du boîtier (10) dans la position de montage par l'intermédiaire de ladite au moins une pièce de raccordement (13, 13A-13G).

13. Appareil électronique (1) selon l'une des revendications précédentes, **caractérisé en ce que** ladite au moins une pièce de raccordement (13, 13A-13G) forme un dispositif de bornes avec au moins une ouverture d'enfichage (134) pour le raccordement d'un conducteur électrique, un élément de paroi plat fermé pour la fermeture du boîtier (10) ou un élément de grille.

14. Appareil électronique (1) selon l'une des revendications précédentes, **caractérisé par** un dispositif de fixation (105) pour relier l'appareil électronique (1) à un rail de support (2).

15. Procédé de fabrication d'un appareil électronique (1), dans lequel une carte à circuit imprimé (12) est insérée le long d'une direction d'insertion (E) dans un espace de réception (15) d'un boîtier (10), qui est formé entre deux parois latérales (100, 101), qui sont espacées l'une de l'autre le long d'une direction de montage (T) orientée transversalement à la direction d'insertion (E), et, dans une position de montage, est reçu dans l'espace de réception (15) dans une position s'étendant perpendiculairement à la direction de montage (T), dans lequel au moins une partie de montage (13, 13A-13G) ayant au moins un logement d'engagement (132) est montée sur un bord latéral (121, 122) de la carte à circuit imprimé et est reliée à la carte à circuit imprimé (12) dans une position montée, et la partie de montage fournit une partie de façade pour une connexion électrique reliée à la carte à circuit imprimé,
**caractérisé**
**en ce que** ladite au moins une pièce de raccordement présente deux premiers dispositifs de guidage (133) pour le guidage sur des deuxièmes dispositifs de guidage (107) des parois latérales (100, 101), ladite au moins une pièce de raccordement (13, 13A-13G) étant apte à être monté sur le boîtier (10) conjointement avec la carte à circuit imprimé (12) de telle sorte que, lors de l'insertion de la carte à circuit imprimé (12) dans l'espace de réception (15), ladite au moins une pièce de raccordement (13, 13A-13G) est guidée de manière à pouvoir coulisser le long de la direction d'insertion (E) par l'intermédiaire des premiers dispositifs de guidage (133) sur les deuxièmes dispositifs de guidage (107) des parois latérales (100, 101) du boîtier (10) et relie entre elles les parois latérales (100, 101) par complémentarité de forme dans la position de montage.
